## Europäisches Patentamt

(19) **European Patent Office**

**Office européen des brevets**

(11) Veröffentlichungsnummer: **0 204 979**

**B1**

(12) **EUROPÄISCHE PATENTSCHRIFT**

(45) Veröffentlichungstag der Patentschrift: 29.03.89

(21) Anmeldenummer: **86106486.3**

(22) Anmeldetag: **13.05.86**

(51) Int. Cl.⁴: **H 01 L 21/82, H 01 L 27/06**

(54) Verfahren zum gleichzeitigen Herstellen von bipolaren und komplementären MOS-Transistoren auf einem gemeinsamen Siliziumsubstrat.

(30) Priorität: **03.06.85 DE 3519790**

(43) Veröffentlichungstag der Anmeldung: **17.12.86 Patentblatt 86/51**

(45) Bekanntmachung des Hinweises auf die Patenterteilung: **29.03.89 Patentblatt 89/13**

(84) Benannte Vertragsstaaten: **AT DE FR GB IT NL**

(56) Entgegenhaltungen:
EP-A-0 078 571
EP-A-0 101 000
EP-A-0 110 313
DE-A-3 023 616

IBM TECHNICAL DISCLOSURE BULLETIN, Band 24, Nr. 1B, Seiten 466-470, Juni 1981, New York, US; J.A. DORLER et al.: "Complementary bipolar-FET integrated circuit"
IEEE TRANSACTIONS ON ELECTRON DEVICES, Band ED-32, Nr. 2, Februar 1985, Seiten 217-223, IEEE, New York, US; H. MOMOSE et al.: "1.0-muM n-well CMOS/bipolar technology"

(73) Patentinhaber: **Siemens Aktiengesellschaft Berlin und München, Wittelsbacherplatz 2, D-8000 München 2 (DE)**

(72) Erfinder: **Jacobs, Erwin P., Dr., Millöckerstr. 76, D-8011 Vaterstetten (DE)**
Erfinder: **Winnerl, Josef, Dr., Schubertstrasse 2, D-8300 Landshut (DE)**

## Beschreibung

Die Erfindung betrifft ein Verfahren zum gleichzeitigen Herstellen von bipolaren und komplementären MOS (CMOS)-Transistoren auf einem gemeinsamen Siliziumsubstrat, bei dem für die Aufnahme der p-Kanal-Transistoren im p-dotierten Siliziumsubstrat n-dotierte Wannen erzeugt werden und in die n-dotierten Wannen isolierte npn-Bipolar-Transistoren gelegt werden, wobei die n-Wanne den Kollektor des Transistors bildet und bei dem die n-Wannen vergrabene n+-dotierte Zonen bedecken, die im Bipolar-Transistorbereich durch tiefreichende Kollektoranschlüsse angeschlossen werden.

Ein solches Verfahren für eine 1,0 μm Wannen-CMOS/Bipolar-Technik für höchstintegrierte Schaltungen ist beispielsweise aus einem Aufsatz von Miyamoto et. al. aus dem IEDM 1983, Technical Digest (Dec. 83), auf den Seiten 63 bis 66, zu entnehmen. Zur Verringerung des Kollektorwiderstandes wird ein vergrabener Kollektor verwendet, der durch einen tiefen Kollektorkontakt angeschlossen wird.

Bei der Herstellung der bekannten Transistoranordnung wird durch die Prozeßfolge ein Kollektor mit hochdotiertem Anschluß erzeugt. Bedingt durch den Temperprozeß zur Erzeugung des tiefen Kollektoranschlusses, der nach dem LOCOS-Prozeß zur Herstellung des Isolationsoxids zur Trennung der aktiven Transistorbereiche durchgeführt wird, tritt eine Temperaturbelastung auf, die sich nachteilig auf die Bauelementstrukturen auswirkt. Außerdem entsteht ein lateraler parasitärer Substrat-pnp, der unter anderem die Latchup-Anfälligkeit erhöht.

Aufgabe der Erfindung ist es, diese Nachteile durch eine geänderte Prozeßführung zu vermeiden und ein Verfahren anzugeben, mit dem es möglich ist, vertikale npn- und laterale pnp-Bipolar-Transistoren und komplementäre MOS-Transistoren auf einem Chip herzustellen.

Diese Aufgabe wird durch ein Verfahren der eingangs genannten Art gelöst, welches erfindungsgemäß durch den Ablauf folgender Verfahrensschritte gekennzeichnet ist:

a) Herstellen der vergrabenen n+-dotierten Zonen im p-dotierten Substrat durch Implantation von n-dotierenden Ionen nach vorheriger Maskierung der übrigen Bereiche,

b) ganzflächiges Aufbringen einer p-dotierten Epitaxieschicht,

c) Erzeugung einer ganzflächigen Isolations-Doppelschicht aus Siliziumoxid und Siliziumnitrid,

d) Festlegung der Bereiche für den tiefreichenden Kollektoranschluß durch eine Tiefimplantation mit n-dotierenden Ionen nach vorheriger Strukturierung der Siliziumnitridschicht durch Fotolithographie,

e) Erzeugen der n-Wannen im Substrat durch Implantation von n-dotierenden Ionen nach Ablösen der Siliziumnitridstrukturen über den n-Wannenbereichen,

f) Eindiffusion der implantierten, n-dotierenden Ionen in das Substrat und gleichzeitige Oxidation der Oberfläche in den n-Wannenbereichen,

g) Durchführung einer Tiefimplantation von Bor-Ionen zur Herstellung des oberflächenfernen Bereichs der Kanalzone der n-Transistoren nach Entfernung der verbliebenen Siliziumnitridschicht, wobei das Oxid als Maske wirkt,

h) Aufbringen einer aus Siliziumoxid und Siliziumnitrid bestehenden Doppelschicht und entsprechende Strukturierung der Siliziumnitridschicht für die nachfolgende lokale Oxidation (LOCOS).

i) Durchführung einer Bor-Ionenimplantation zur Dotierung der Feldbereiche der n-Kanal-Transistoren nach vorheriger Fotolackmaskierung der übrigen Bereiche,

j) Herstellung des für die Trennung der aktiven Transistorbereiche im Substrat erforderlichen Feldoxids durch lokale Oxidation nach Entfernung der Fotolackmaske und unter Verwendung der Siliziumnitrid-Struktur als Oxidationsmaske,

k) Herstellung der Basiszone im Bipolartransistorbereich durch Bor-Ionenimplantation nach vorheriger Fotolackmaskierung der übrigen Bereiche,

l) ganzflächige Oxidation zur Erzeugung des Gateoxids nach Entfernung der Fotolackmaske und des Streuoxids,

m) Durchführung einer ganzflächigen, flachen Bor-Ionenimplantation zur Dotierung der Kanalbereiche der n- und p-Kanal-MOS-Transistoren,

n) Herstellung der Gate-Elektroden der MOS-Transistoren durch ganzflächige Abscheidung des Gatematerials und anschließender Strukturierung,

o) Abscheidung einer ganzflächigen, als Zwischenoxid wirkenden Siliziumoxid-Schicht aus der Gasphase,

p) gleichzeitige Herstellung der Source/Drain-Bereiche der n-Kanal-Transistoren, des Emitters und des n+-Kollektorkontakts der Bipolartransistoren durch Implantation von n-dotierenden Ionen nach vorheriger Fotolackmaskierung der p-Kanal-Transistor-Bereiche und der Bipolar-Transistor-Bereiche mit Ausnahme des Emitterbereiches und des n+-Kollektorbereiches,

q) gleichzeitige Herstellung der Source/Drain-Bereiche der p-Kanal-Transistoren und des p+-Basiskontakts der Bipolar-Transistoren durch Bor-Ionenimplantation nach vorheriger Fotolackmaskierung der n-Kanal-Transistorbereiche und der Bipolar-Transistorbereiche mit Ausnahme des p+-Basisbereiches und

r) Entfernung der Fotolackmaske, Freilegung der Kontaktlochbereiche, Durchführung der Metallisierung zur Herstellung der Anschlußelektroden und Passivierung.

Diese Verfahrens folge stellt eine besonders vorteilhafte Variation des aus der DE-OS-3 314 450 Al bekannten Verfahrens zum Herstellen von hochintegrierten komplementären MOS-Feldeffekttransistorschaltungen dar, enthält aber Verfahrensschritte, die die gleichzeitige Herstellung von Bipolar-Transistoren auf dem gleichen Chip ermöglichen.

Weitere Ausgestaltungen der Erfindung ergeben sich aus den Unteransprüchen.

Durch das Verfahren nach der Lehre der Erfindung werden gegenüber den zum Beispiel aus dem Aufsatz von Miyamoto bekannten Verfahren folgende Vorteile erreicht:

1. Der Hochtemperaturschritt nach dem LOCOS-Prozeß kann durch die gemeinsame Eindiffusion von n-Wanne und tiefem Kollektoranschluß eingespart werden.

2. Durch die selbstjustierende Wannenimplantation zur Implantation des tiefreichenden Kollektoranschlusses entsteht dieser ringförmig um die Wanne.

3. Durch den ringförmigen Kollektoranschluß in Verbindung mit dem vergrabenen Kollektor wird der Wannenwiderstand verringert. Dies führt sowohl zu einer Verringerung des Kollektorbahnwiderstandes des Bipolartransistors als auch zu einer erhöhten latch-up-Festigkeit der Schaltungen.

4. Der parasitäre Substrat-pnp wird vertikal durch den vergrabenen Kollektor und lateral durch den ringförmigen Kollektoranschluß reduziert. Dadurch wird die latch-up-Festigkeit ebenfalls erhöht.

5. Der reduzierte Substrat-pnp ermöglicht einen lateralen pnp-Transistor in der n-Wanne.

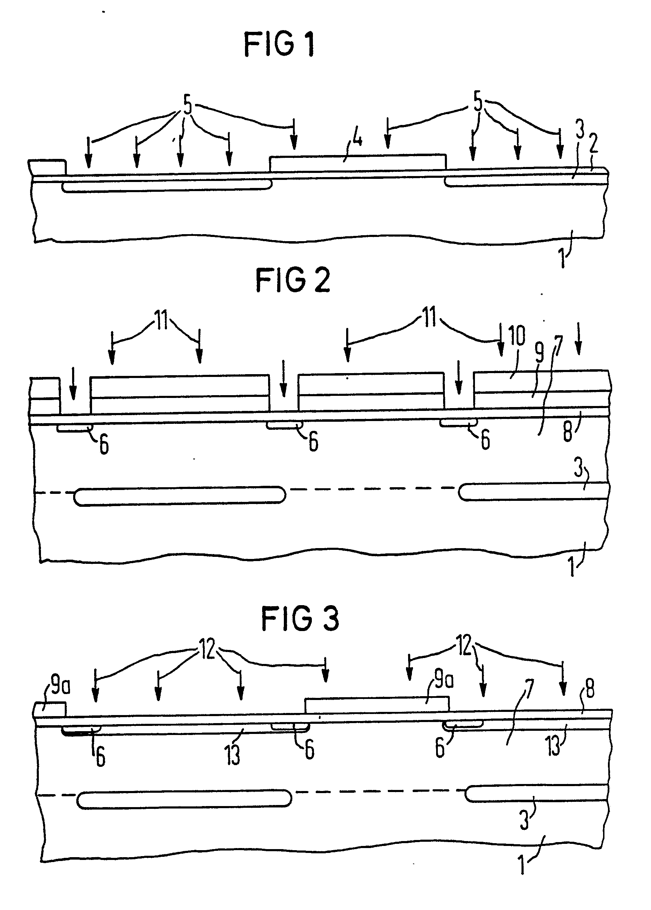

Im folgenden wird anhand der Figuren 1 bis 15 und eines Ausführungsbeispiels der Prozeßablauf für die gleichzeitige Herstellung von bipolaren und komplementären MOS (CMOS)-Transistoren auf einem gemeinsamen Chip nach der Lehre der Erfindung noch näher beschrieben. Dabei sind in den Figuren im Schnittbild die Verfahrensschritte zusammengefaßt dargestellt; für gleiche Teile sind gleiche Bezugszeichen vorgesehen.

**Figur 1:** Auf einer einkristallinen p-dotierten, (100)-orientierten Siliziumsubstratscheibe 1 mit einem spezifischen elektrischen Widerstand von 20 Ohm cm und einer $SiO_2$-Schicht 2 wird zunächst der vergrabene Kollektorbereich 3 dadurch erzeugt, daß nach erfolgter Fotolackmaskierung 4 eine Antimon-Ionenimplantation 5 mit einer Dosis und Energie von $3 \times 10^{15}$ $Sb^+$ $cm^{-2}$ und 80 keV durchgeführt wird.

**Figur 2:** Die Bereiche für den tiefen Kollektoranschluß 6 werden dadurch hergestellt, daß auf die in Figur 1 dargestellte Anordnung nach Entfernung der $SiO_2$-Schicht 2 eine 3 μm-dicke p--dotierte Epitaxieschicht 7 mit einem spezifischen elektrischen Widerstand von 20 Ohm·cm abgeschieden wird, die Epitaxieschicht 7 mit einer isolierenden Doppelschicht, bestehend aus einer 50 nm dicken $SiO_2$-Schicht 8

und einer 140 nm dicken CVD-Siliziumnitridschicht 9 bedeckt wird. Durch die Fotolacktechnik 10 wird die Nitridschicht 9 strukturiert und anschließend die Kollektortiefimplantation 11 mit Phosphor-Ionen bei einer Dosis und Energie von $3 \times 10^{15}$ $cm^{-2}$ und 80 keV durchgeführt. Hier tritt bereits eine Abweichung gegenüber bekannten Prozessen auf.

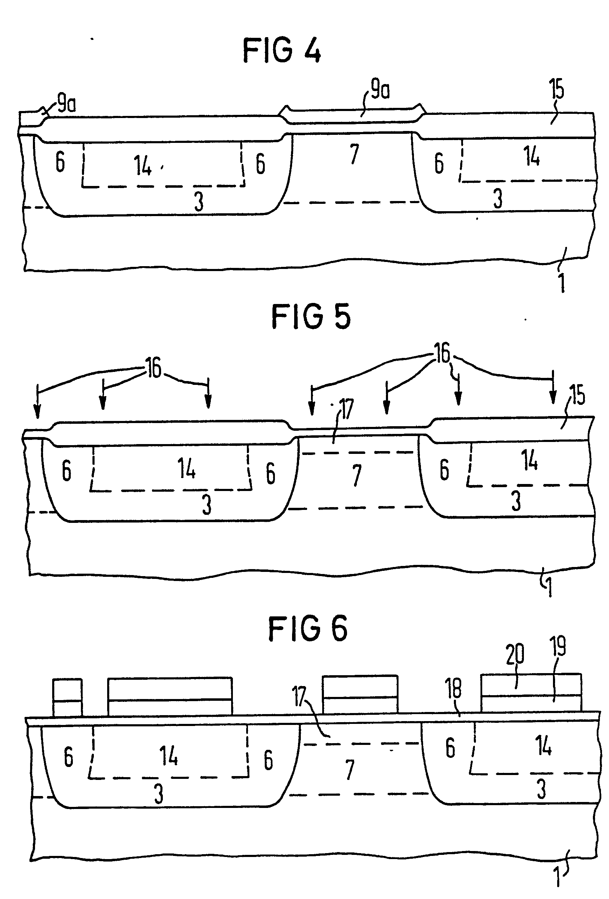

**Figur 3:** zeigt die Erzeugung der n-Wannenbereiche (14 in Figur 4) durch eine Phosphor-Ionenimplantation 12 mit einer Dosis und Energie von $2 \times 10^{12}$ $cm^{-2}$ und 180 keV nach erfolgter Fotolacktechnik (nicht dargestellt) und Entfernung der Nitridstrukturen über den n-Wannenbereichen (14). Es bleibt die Nitridstrukturierung 9a und es entstehen die implantierten Bereiche 13.

**Figur 4:** Nun erfolgt die Oxidation zur Maskierung der Wannenbereiche (13) und gleichzeitig die Eindiffusion der Antimon- und Phosphor-Ionen, das heißt der drive-in von n-Wanne 14 und Kollektoranschluß 6. Auf der Oberfläche entsteht eine $SiO_2$-Schicht 15, wobei die Nitridmaske 9a als Maskierung dient. Bei dieser Temperaturbehandlung (1150° C) wird der Kollektoranschluß 6 ca. 3 μm in das Substrat 1 eingetrieben, so daß der vergrabene Kollektorbereich 3 sicher erreicht wird.

**Figur 5:** Die erste tiefe Implantation der Doppel Kanalimplantation der n-Kanal-Transistoren erfolgt nach Entfernung der Siliziumnitridstruktur 9a durch ganzflächige Tiefimplantation 16 mit Bor-Ionen bei einer Dosis und Energie von $8 \times 10^{11}$ $cm^{-2}$ und 60 keV, wobei die $SiO_2$-Schicht 15 als Maske wirkt. Es entsteht der p-dotierte Bereich 17 unter dem Kanal.

**Figur 6:** Es folgt die Erzeugung einer aus thermischem $SiO_2$ (50 nm) und abgeschiedenem Siliziumnitrid (140 nm) bestehenden Doppelschicht 18, 19 und entsprechende Strukturierung der Siliziumnitridschicht 19 mit der Fotolacktechnik 20 als Maskierung für die später folgende lokale Oxidation (LOCOS).

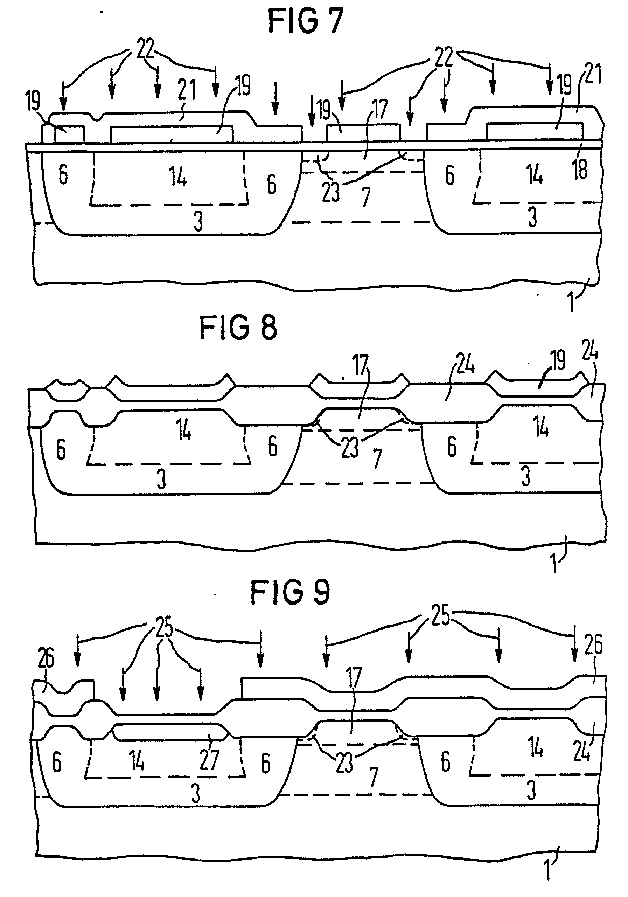

**Figur 7:** Zur Erzeugung der Felddotierung im n-Kanalbereich wird nach erneuter Fotolacktechnik 21 eine Bor-Ionenimplantation 22 mit einer Dosis und Energie von $1,2 \times 10^{13}$ $cm^{-2}$ und 25 keV durchgeführt. Es entstehen die p-dotierten Bereiche 23.

**Figur 8:** Nun wird für das für die Trennung der aktiven Transistorbereiche im Substrat 1 erforderliche Feldoxid 24 durch lokale Oxidation unter Verwendung der Siliziumnitridmaskierung 19 nach Entfernung der Fotolackmaske 21 auf der $SiO_2$-Schicht 18 in einer Schichtdicke von 850 nm erzeugt. Die beiden Oxidschichten werden ab jetzt mit dem Bezugszeichen 24 bezeichnet.

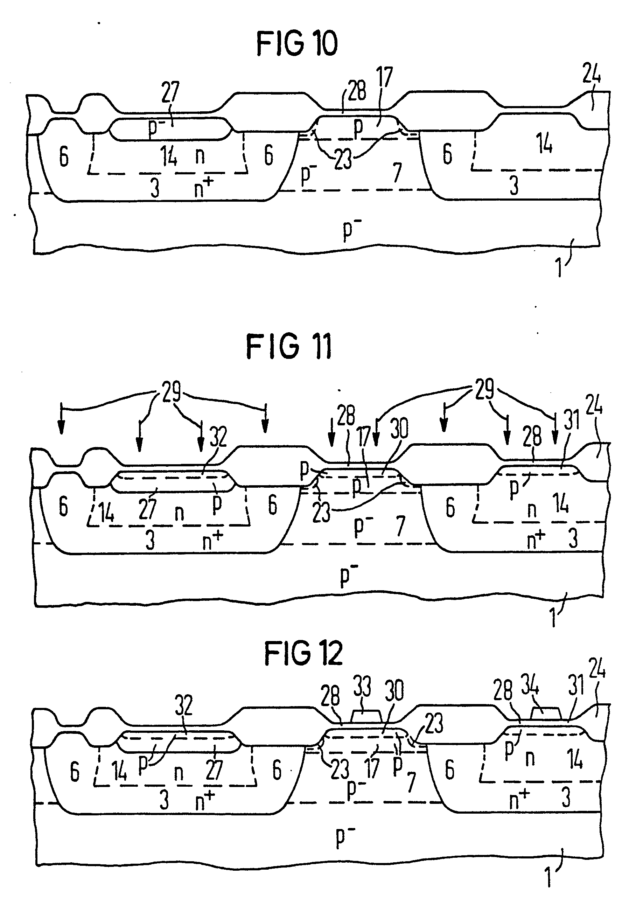

**Figur 9:** Nun erfolgt die Basisimplantation 25 des Bipolar-Transistors nach vorheriger Fotolackmaskierung 26 mit Bor-Ionen mit einer Dosis und Energie von $9 \times 10^{13}$ $cm^{-2}$ und 80 keV. Es entsteht die p-dotierte Basiszone 27.

**Figur 10:** Es folgt die Gateoxidation nach vorheriger Entfernung des Fotolacks und des Streuoxids 18. Die Dicke des Gateoxids 28 wird auf 25 nm eingestellt.

**Figur 11:** zeigt, wie durch die ganzflächige zweite, flache Kanalimplantation 29 mit Borionen mit einer Dosis und Energie von $2 \times 10^{11}$ cm$^{-2}$ und 25 keV die Kanalbereiche 30 und 31 der MOS-Transistoren und der p-Bereich 32 in der Basis des Bipolartransistors erzeugt werden. Der besseren Unterscheidung der Zonen sind in den Figuren die entsprechenden Dotierungen in den Bereichen eingezeichnet.

**Figur 12:** Die Gate-Elektroden 33, 34 der MOS-Transistoren werden dadurch erzeugt, daß eine ganzflächige Tantaldisilizidabscheidung durchgeführt wird und anschließend die Elektroden 33, 34 mittels Fotolacktechnik (in der Figur nicht dargestellt) strukturiert werden.

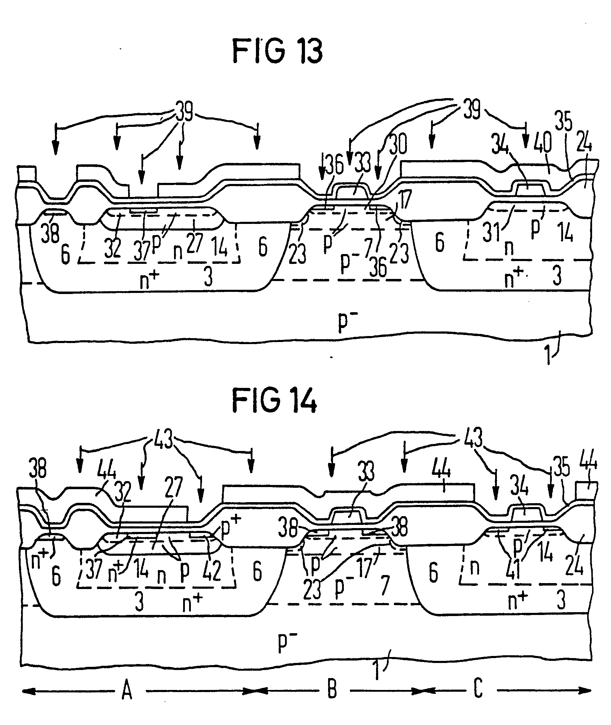

**Figur 13:** Dann wird das Zwischenoxid 35 durch ganzflächige Abscheidung von SiO$_2$ aus der Gasphase erzeugt. Dabei hat es sich als vorteilhaft erwiesen, diese Schicht 35 durch thermische Zersetzung von Tetraethylorthosilikat (TEOS) zu erzeugen, wobei bei der Abscheidung eine konforme Spacerschicht (35) in 100 nm Dicke entsteht. Dann erfolgt die gleichzeitige Herstellung der Source/Drain-Bereiche 36 der n-Kanaltransistoren, des Emitters 37 und des n+-Kollektorkontaktbereichs 38 der Bipolartransistoren durch Phosphorionenimplantation 39 bei einer Dosis und Energie von $8 \times 10^{15}$ cm$^{-2}$ und 80 keV nach Maskierung der übrigen Bereiche (p-Kanal-Transistoren, Bipolar-Transistorbereich mit Ausnahme des Kollektorkontaktbereiches 38 und des Emitterbereichs 37) mit Fotolack 40.

**Figur 14:** In analoger Weise wie in Figur 13 beschrieben, werden die Source/Drain-Bereiche 41 der p-Kanal-Transistoren und der p+-Basiskontaktbereich 42 des Bipolartransitors durch eine Bor-Ionenimplantation 43 mit einer Dosis und Energie von $4 \times 10^{15}$ cm$^{-2}$ und 40 keV erzeugt. Dabei werden die n-Kanal-Transistorbereiche und der Bipolar-Transistorbereich mit Ausnahme des p+-Basiskontaktbereiches 42 mit einer Fotolackmaske 44 abgedeckt.

Die unter der Figur eingezeichneten Buchstaben (A, B und C) markieren den Bereich des Bipolar-Transistors A und die Bereiche des n-Kanal-Transistors B sowie des p-Kanal-Transistors C.

In einer Version des erfindungsgemäßen Verfahrens ist es auch möglich, von einem p-dotierten Substrat mit einem spezifischen elektrischen Widerstand von 0,02 Ohm·cm auszugehen und die in Figur 1 dargestellte Implantation zur Erzeugung des vergrabenen Kollektors wegzulassen oder bei einem Ausgangsmaterial von 20 Ohm·cm die in Figur 1 dargestellte Implantation wegzulassen und die in Figur 3 dargestellte Epitaxie-Schicht nicht aufzubringen. Durch die Einsparung des vergrabenen Kollektors ergibt sich eine Prozeßvereinfachung, wobei der ringförmige Kollektoranschluß gegenüber herkömmlichen Prozessen ohne vergrabenen Kollektor eine Verbesserung im Kollektorwiderstand und zu der Latch-up-Festigkeit ergibt.

**Patentansprüche**

1. Verfahren zum gleichzeitigen Herstellen von bipolaren (A) und komplementären MOS (CMOS)-Transistoren (B, C) auf einem gemeinsamen Siliziumsubstrat (1), bei dem für die Aufnahme der p-Kanal-Transistoren (C) im p-dotierten Siliziumsubstrat (1) n-dotierte Wannen (14) erzeugt werden und in die n-dotierten Wannen (14) isolierte npn-Bipolar-Transistoren (A) gelegt werden, wobei die n-Wanne (14) den Kollektor des Transistors (A) bildet und bei dem die n-Wannen (14) vergrabene n+-dotierte Zonen (3) bedecken, die im Bipolar-Transistorbereich (A) durch tiefreichende Kollektoranschlüsse angeschlossen werden, gekennzeichnet durch den Ablauf folgender Verfahrensschritte:

a) Herstellen der vergrabenen n+-dotierten Zonen (3) im p-dotierten Substrat (1) durch Implantation (5) von n-dotierenden Ionen nach vorheriger Maskierung (4) der übrigen Bereiche,

b) ganzflächiges Aufbringen einer p-dotierten Epitaxie-Schicht (7),

c) Erzeugung einer ganzflächigen Isolations-Doppelschicht aus Siliziumoxid (8) und Siliziumnitrid (9),

d) Festlegung der Bereiche für den tiefreichenden Kollektoranschluß (6) durch eine Tiefimplantation (11) mit n-dotierenden Ionen nach vorheriger Strukturierung der Siliziumnitridschicht (9) durch Fotolithographie (10),

e) Erzeugen der n-Wannen (14) im Substrat (1) durch Implantation (12) von n-dotierenden Ionen nach Ablösen der Siliziumnitridstrukturen über den n-Wannenbereichen (14),

f) Eindiffusion der implantierten, n-dotierenden Ionen in das Substrat (1) und gleichzeitige Oxidation (15) der Oberfläche in den n-Wannenbereichen (14),

g) Durchführung einer Tiefimplantation (16) von Bor-Ionen zur Herstellung des oberflächenfernen Bereichs der Kanalzone (17) der n-Transistoren (B) nach Entfernung der Siliziumnitridstrukturen (9a), wobei das Oxid (15) als Maske wirkt,

h) Aufbringen einer aus Siliziumoxid (18) und Siliziumnitrid (19) bestehenden Doppelschicht und entsprechende Strukturierung der Siliziumnitridschicht (19) für die nachfolgende lokale Oxidation (LOCOS),

i) Durchführung einer Bor-Ionenimplantation (22) zur Dotierung der Feldoxidbereiche (23) der n-Kanal-Transistoren nach vorheriger Fotolackmaskierung (21) der übrigen Bereiche,

j) Herstellung des für die Trennung der aktiven Transistorbereiche (A, B, C) im Substrat (1) erforderlichen Feldoxids (24) durch lokale Oxidation nach Entfernung der Fotolackmaske (21) und unter Verwendung der Siliziumnitrid-Struktur (19) als Oxidationsmaske,

k) Herstellung der Basiszone (27) im Bipolartransistorbereich (A) durch Bor-Ionenimplantation (25) nach vorheriger Fotolackmaskierung (26) der übrigen Bereiche,

l) ganzflächige Oxidation zur Erzeugung des Gateoxids (28) nach Entfernung der Fotolackmaske (26) und des Streuoxids (18),

m) Durchführung einer ganzflächigen, flachen Bor-Ionenimplantation (29) zur Dotierung der Kanalbereiche der n- und p-Kanal MOS-Transistoren,

n) Herstellung der Gate-Elektroden (33, 34) der MOS-Transistoren (B, C) durch ganzflächige Abscheidung des Gatematerials und anschließender Strukturierung,

o) Abscheidung einer ganzflächigen, als Zwischenoxid (35) wirkenden Siliziumoxid-Schicht aus der Gasphase,

p) gleichzeitige Herstellung der Source/Drain-Bereiche (38) der n-Kanal-Transistoren (B), des Emitters (37) und des n+-Kollektorkontakts (38) der Bipolartransistoren (A) durch Implantation (39) von n-dotierenden Ionen nach vorheriger Fotolackmaskierung (40) der p-Kanal-Transistor-Bereiche (C) und der Bipolartransistor-Bereiche (A) mit Ausnahme des Emitterbereiches (37) und des n+-Kollektorbereiches (38),

q) gleichzeitige Herstellung der Source/Drain-Bereiche (41) der p-Kanal-Transistoren (C) und des p+-Basiskontakts (42) der Bipolartransistoren (A) durch Bor-Ionenimplantation (43) nach vorheriger Fotolackmaskierung (44) der n-Kanal-Transistorbereiche (B) und der Bipolartransistorbereiche (A) mit Ausnahme des p+-Basisbereiches (42),

r) Entfernung der Fotolackmaske (44), Freilegung der Kontaktlochbereiche, Durchführung der Metallisierung zur Herstellung der Anschlußelektroden und Passivierung.

2. Verfahren nach Anspruch 1, dadurch gekennzeichnet, daß ein p-dotiertes, (100)-orientiertes Siliziumsubstrat (1) mit einem spezifischen elektrischen Widerstand von 20 Ohm·cm verwendet wird.

3. Verfahren nach Anspruch 1, dadurch gekennzeichnet, daß ein p-dotiertes (100)-orientiertes Siliziumsubstrat (1) mit einem spezifischen elektrischen Widerstand von 0,02 Ohm·cm verwendet wird und daß der Verfahrensschritt a) entfällt.

4. Verfahren nach Anspruch 1 und 2, dadurch gekennzeichnet, daß die Verfahrensschritte a) und b) entfallen.

5. Verfahren nach mindestens einem der Ansprüche 1 bis 4, dadurch gekennzeichnet, daß die Ionenimplantation (5) nach Verfahrensschritt a) mit Antimon bei einer Dosis und Energie von 3 x $10^{15}$ cm$^{-2}$ und 80 keV durchgeführt wird.

6. Verfahren nach mindestens einem der Ansprüche 1 bis 5, dadurch gekennzeichnet, daß der spezifische elektrische Widerstand der p-dotierten Epitaxie-Schicht (7) nach Verfahrensschritt b) auf 20 Ohm·cm und die Schichtdicke auf ca. 3 μm eingestellt wird.

7. Verfahren nach mindestens einem der Ansprüche 1 bis 6, dadurch gekennzeichnet, daß die Isolationsdoppelschicht (8, 9) nach Verfahrensschritt c) durch eine 50 nm dicke thermische SiO$_2$-Schicht (8) und eine aus der Gasphase (CVD) abgeschiedene 140 nm dicke Siliziumnitridschicht gebildet wird.

8. Verfahren nach mindstens einem der Ansprüche 1 bis 7, dadurch gekennzeichnet, daß die Kollektor-Tiefimplantation nach Verfahrensschritt d) mit Phosphor-Ionen mit einer Dosis und Energie von 3 x $10^{15}$ cm$^{-2}$ und 80 keV durchgeführt wird.

9. Verfahren nach mindestens einem der Ansprüche 1 bis 8, dadurch gekennzeichnet, daß die Wannenimplantation (12) nach Verfahrensschritt e) mit Phosphor-Ionen mit einer Dosis und Energie von 2 x $10^{12}$ cm$^{-2}$ und 180 keV durchgeführt wird.

10. Verfahren nach mindestens einem der Ansprüche 1 bis 9, dadurch gekennzeichnet, daß das Eintreiben der implantierten Ionen und die Oberflächen-Oxidation nach Verfahrensschritt f) so durchgeführt wird, daß die n-dotierten Bereiche (6, 14) mindestens 2.5 μm in das p-dotierte Siliziumsubstrat (1) eindringen.

11. Verfahren nach mindestens einem der Ansprüche 1 bis 10, dadurch gekennzeichnet, daß die erste tiefe Kanalimplantation (16) nach Verfahrensschritt g) mit einer Dosis und Energie von 8 x $10^{11}$ B+ cm$^{-2}$ und 60 keV durchgeführt wird.

12. Verfahren nach mindestens einem der Ansprüche 1 bis 11, dadurch gekennzeichnet, daß die n-Kanal-Feld-Implantation (22) nach Verfahrensschritt i) mit einer Dosis und Energie von 1,2 x $10^{13}$ B+ cm$^{-2}$ und 25 keV durchgeführt wird.

13. Verfahren nach mindestens einem der Ansprüche 1 bis 12, dadurch gekennzeichnet, daß die Bor-Ionenimplantation (25) zur Herstellung der Basiszone (27) nach Verfahrensschritt k) bei einer Dosis und Energie von 9 x $10^{13}$ B+ cm$^{-2}$ und 80 keV durchgeführt wird.

14. Verfahren nach mindestens einem der Ansprüche 1 bis 13, dadurch gekennzeichnet, daß die Gateoxidation nach Verfahrensschritt l) so durchgeführt wird, daß die Gateoxiddicke (28) im Bereich von 10 - 25 nm liegt.

15. Verfahren nach mindestens einem der Ansprüche 1 bis 14, dadurch gekennzeichnet, daß die ganzflächige Bor-Kanal-Ionenimplantation (29) nach Verfahrensschritt m) bei einer Dosis und Energie von 2 x $10^{11}$ B+ cm$^{-2}$ und 25 keV durchgeführt wird.

16. Verfahren nach mindestens einem der Ansprüche 1 bis 15, dadurch gekennzeichnet, daß als Gatematerialien (33, 34) nach Verfahrensschritt n) hochschmelzende Metalle (refractory metals), Silizide hochschmelzender Metalle, vorzugsweise Tantaldisilizid, oder Doppelschichten aus Polysilizium und Siliziden verwendet werden.

17. Verfahren nach mindestens einem der Ansprüche 1 bis 16, dadurch gekennzeichnet, daß die ganzflächige Siliziumoxid-Schicht (35) nach Verfahrensschritt o) in einer Schichtdicke im Bereich von 50 - 200 nm durch thermische Zersetzung von Tetraethylorthosilikat hergestellt wird.

18. Verfahren nach mindestens einem der Ansprüche 1 bis 17, dadurch gekennzeichnet, daß die Source/Drain-Implantationen (39, 43) nach den Verfahrensschritten p) und q) bei einer SiO$_2$-Schichtdicke (35) von 100 nm mit Phosphor bzw. Bor-Ionen bei einer Dosis und Energie von 8 x 10$^{15}$ cm$^{-2}$ bzw. 4 x 10$^{15}$ cm$^{-2}$ und 80 bzw. 40 keV durchgeführt werden.

19. Verfahren nach mindestens einem der Ansprüche 1 bis 17, dadurch gekennzeichnet, daß die Source/Drain-Implantationen (39/43) nach den Verfahrensschritten p) und q) bei einer SiO$_2$-Schichtdicke (35) von 70 nm mit Phosphor bzw. Bor-Ionen bei einer Dosis und Energie von 4 x 10$^{15}$ cm$^{-2}$ und 80 bzw. 40 keV durchgeführt werden.

20. Integrierte Bipolar- und komplementäre MOS (CMOS)-Transistoren enthaltende Halbleiteranordnung mit einem bezüglich der Dotierung unterschiedlichen Kollektor (3, 6, 14) mit selbstjustierend ringförmig tiefreichend ausgebildetem Kollektoranschluß (6) hergestellt nach dem Verfahren nach mindestens einem der Ansprüche 1 bis 19.

## Claims

1. Method of simultaneously producing bipolar (A) and complementary MOS (CMOS) transistors (B, C) on a common silicon substrate (1) in which n-doped tubs (14) are produced in the p-doped silicon substrate (1) for receiving the p-channel transistors (C) and isolated npn bipolar transistors (A) are laid down in the n-doped tubs (14), the n-type tub (14) forming the collector of the transistor (A), and in which the n-type tubs (14) cover buried n+-doped zones (3) which are connected by deeply extending collector connections in the bipolar transistor region (A), characterized by the sequence of following process steps:

a) production of the buried n+-doped zones (3) in the p-doped substrate (1) by implantation (5) of n-doping ions after prior masking (4) of the remaining regions,

b) application of a p-doped epitaxial layer (7) over the entire surface,

c) production of a double-isolation layer composed of silicon oxide (8) and silicon nitride (9) over the entire surface,

d) establishment of the regions for the deeply extending collector connection (6) by a deep implantation (11) with n-doping ions after prior structuring of the silicon nitride layer (9) by photolithography (10),

e) production of the n-type tubs (14) in the substrate (1) by implantation (12) of n-doping ions after stripping the silicon nitride structures above the n-type tub regions (14),

f) diffusion of the implanted n-doping ions into the substrate (1) and simultaneous oxidation (15) of the surface in the n-type tub regions (14),

g) carrying out of a deep implantation (16) of boron ions to produce the region of the channel zone 17, remote from the surface, of the n-channel transistors (B) after removing the silicon nitride structures (9a), the oxide (15) acting as a mask,

h) application of a double layer composed of silicon oxide (18) and silicon nitride (19) and suitable structuring of the silicon nitride layer (19) for the subsequent local oxidation (LOCOS),

i) carrying out of a boron ion implantation (22) to dope the field oxide regions (23) of the n-channel transistors after prior photoresist masking (21) of the remaining regions,

j) production of the field oxide (24) required to separate the active transistor regions (A, B, C) in the substrate (1) by local oxidation after removal of the photoresist mask (21) and using the silicon nitride structure (19) as oxidation mask,

k) production of the base zone (27) in the bipolar transistor region (A) by boron ion implantation (25) after prior photoresist masking (26) of the remaining regions,

l) oxidation over the entire surface to produce the gate oxide (28) after removing the photoresist mask (26) and the dispersed oxide (18),

m) carrying out of a shallow boron ion implantation (29) over the entire surface to dope the channel regions of the n- and p-channel MOS transistors,

n) production of the gate electrodes (33, 34) of the MOS transistors (B, C) by deposition of the gate material over the entire surface and subsequent structuring,

o) deposition from the gas phase of a silicon oxide layer, which acts as an intermediate oxide (35) over the entire surface,

p) simultaneous production of the source/drain regions (38) of the n-channel transistors (B), of the emitter (37) and of the n+-collector contact (38) of the bipolar transistors (A) by implantation (39) of n-doping ions after prior photoresist masking (40) of the p-channel transistor regions (C) and of the bipolar transistor regions (A) with the exception of the emitter region (37) and of the n+-collector region (38),

q) simultaneous production of the source/drain regions (41) of the p-channel transistors (C) and of the p+-base contact (42) of the bipolar transistors (A) by boron ion implantation (43) after prior photoresist masking (44) of the n-channel transistor regions (B) and of the bipolar transistor regions (A) with the exception of the p+-base region (42),

r) removal of the photoresist mask (44), uncovering of the contact hole regions, carrying out of the metallisation to produce the contact electrodes and passivation.

2. Method according to Claim 1, characterized in that a p-doped (100)-oriented silicon substrate (1) having a specific electrical resistance of 20 ohm·cm is used.

3. Method according to Claim 1, characterized in that a p-doped (100)-oriented silicon substrate (1) having a specific electrical resistance of 0.02 ohm·cm is used and in that process step a) is omitted.

4. Method according to Claim 1 and 2, characterized in that the process steps a) and b) are omitted.

5. Method according to at least one of the Claims 1 to 4, characterized in that the ion implantation (5) according to process step a) is carried out using antimony with a dosage and energy of $3 \times 10^{15}$ cm$^{-2}$ and 80 keV.

6. Method according to at least one of the Claims 1 to 5, characterized in that the specific electrical resistance of the p-doped epitaxial layer (7) according to process step b) is adjusted to 20 ohm·cm and the layer thickness to approx. 3 μm.

7. Method according to at least one of the Claims 1 to 6, characterized in that the double isolation layer (8, 9) according to process step c) is formed by a 50 nm-thick thermal SiO$_2$ layer (8) and a 140 nm-thick silicon nitride layer deposited from the gas phase (CVD).

8. Method according to at least one of the Claims 1 to 7, characterized in that the deep collector implantation according to process step d) is carried out using phosphorus ions with a dosage and energy of $3 \times 10^{15}$ cm$^{-2}$ and 80 keV.

9. Method according to at least one of the Claims 1 to 8, characterized in that the tub implantation (12) according to process step e) is carried out using phosphorus ions with a dosage and energy of $2 \times 10^{12}$ cm$^{-2}$ and 180 keV.

10. Method according to at least one of the Claims 1 to 9, characterized in that the drive-in of the implanted ions and the surface oxidation according to process step f) are carried out so that the n-doped regions (6, 14) penetrate at least 2.5 μm into the p-doped silicon substrate (1).

11. Method according to at least one of the Claims 1 to 10, characterized in that the first deep channel implantation (16) according to process step g) is carried out with a dosage and energy of $8 \times 10^{11}$ B$^+$ cm$^{-2}$ and 60 keV.

12. Method according to at least one of the Claims 1 to 11, characterized in that the n-channel field implantation (22) according to process step i) is carried out with a dosage and energy of $1.2 \times 10^{13}$ B$^+$ cm$^{-2}$ and 25 keV.

13. Method according to at least one of the Claims 1 to 12, characterized in that the boron ion implantation (25) for producing the base zone (27) according to process step k) is carried out with a dosage and energy of $9 \times 10^{13}$ B$^+$ cm$^{-2}$ and 80 keV.

14. Method according to at least one of the Claims 1 to 13, characterized in that the gate oxidation according to process step l) is carried out so that the gate oxide thickness (28) is in the region of 10 - 25 nm.

15. Method according to at least one of the Claims 1 to 14, characterized in that the boron-channel ion implantation (29) over the entire surface according to process step m) is carried out with a dosage and energy of $2 \times 10^{11}$ B$^+$ cm$^{-2}$ and 25 keV.

16. Method according to at least one of the Claims 1 to 15, characterized in that high-melting metals (refractory metals), silicides of high-melting metals, preferably tantalum disilicide, or double layers composed of polysilicon and silicides are used as gate materials (33, 34) according to process step n).

17. Method according to at least one of the Claims 1 to 16, characterized in that the silicon oxide layer (35) over the entire surface according to process step o) is produced in a layer thickness in the region of 50 - 200 nm by thermal decomposition of tetraethyl orthosilicate.

18. Method according to at least one of the Claims 1 to 17, characterized in that the source/drain implantations (39, 43) according to the process steps p) and q) are carried out with an SiO$_2$ layer thickness (35) of 100 nm using phosphorus and boron ions respectively with a dosage and energy of $8 \times 10^{15}$ cm$^{-2}$ and $4 \times 10^{15}$ cm$^{-2}$ respectively and 80 and 40 keV respectively.

19. Method according to at least one of the Claims 1 to 17, characterized in that the source/drain implantations (39/43) according to process steps p) and q) are carried out with an SiO$_2$ layer thickness (35) of 70 nm using phosphorus and boron ions respectively with a dosage and energy of $4 \times 10^{15}$ cm$^{-2}$ and 80 and 40 keV respectively.

20. Integrated semiconductor system containing bipolar and complementary MOS (CMOS) transistors having a collector (3, 6, 14) differing in relation to the doping with collector connection (6) formed in a self-adjusting, annular and deeply extending manner, produced by the process according to at least one of the Claims 1 to 19.

**Revendications**

1. Procédé pour fabriquer simultanément des transistors bipolaires (A) et des transistors MOS complémentaires (CMOS) (B, C) sur un substrat commun en silicium (1), et selon lequel, pour loger les transistors à canal p (C), on aménage des cuvettes (14) dopées de type n dans le substrat en silicium (1) dopé de type p et on insère, dans les cuvettes (14) dopées de type n, des transistors bipolaires npn isolés (A), la cuvette (14) de type n formant le collecteur du transistor (A), et selon lequel les cuvettes (14) de type n recouvrent des zones ensevelies (3) dopées de type n+, qui sont raccordées par des bornes de collecteur s'étendant en profondeur, dans la région (A) des transistors bipolaires, caractérisé par l'exécution des étapes opératoies suivantes:

a) fabrication des zones ensevelies (3) dopées de type n+ dans le substrat (1) dopé de type p, par implantation d'ions réalisant un dopage de type n, après masquage préalable (4) des autres régions,

b) dépôt, sur toute la surface, d'une couche épitaxiale (7) dopée de type p,

c) production d'une couche double isolante s'étendant sur toute la surface et formée par de l'oxyde de silicium (8) et du nitrure de silicium (9),

d) détermination des zones pour la borne de collecteur (6), qui s'étend en profondeur au moyen d'une implantation profonde (11) avec des ions réalisant un dopage de type n, après structuration préalable de la couche de nitrure de silicium (9) par photolithographie (10),

e) production des cuvettes (14) de type n dans le substrat (1) au moyen d'une implantation (12) d'ions réalisant un dopage de type n, après élimination des structures de nitrure de silicium au-dessus des zones (14) des cuvettes de type n,

f) introduction par diffusion des ions implantés réalisant un dopage de type n, dans le substrat (1) et oxydation simultanée (4) de la surface dans les régions (14) des cuvettes de type n,

g) exécution d'une implantation profonde (16) d'ions de bore pour fabriquer la région, éloignée de la surface, de la zone (17) du canal des transistors de type n (B) après élimination des structures en nitrure de silicium (9a), l'oxyde (15) agissant en tant que masque,

h) dépôt d'une couche double constituée par de l'oxyde de silicium (18) et du nitrure de silicium (19) et structuration correspondante de la couche de niture de silicium (19) pour l'oxydation locale ultérieure (LOCOS),

i) exécution d'une implantation d'ions (22) pour doper les régions (23) d'oxyde de champ des transistors à canal n après masquage préalable (21) des autres régions au moyen d'une laque photosensible,

j) fabrication de l'oxyde de champ (24) nécessaire pour la séparation des régions actives des transistors (A, B, C) dans le substrat (1), au moyen d'une oxydation locale après élimination du masque (20) de laque photosensable et moyennant l'utilisation de la structure de nitrure de silicium (19) en tant que masque d'oxydation,

k) fabrication de la zone de base (27) dans la région (A) du transistor bipolaire par implantation d'ions de bore (25) après masquage préalable (26) des autres régions avec une laque photosensible,

l) oxydation, sur toute la surface, pour produire l'oxyde de grille (28) après élimination du masque (26) de laque photosensible et de l'oxyde de diffusion (18),

m) mise en oeuvre d'une implantation d'ions de bore (29) sur toute la surface et sur une faible profondeur pour réaliser le dopage des régions de canal des transistors MOS à canal n et p,

n) fabrication des électrodes de grille (33, 34) des transistors MOS (B, C) au moyen d'un dépôt du matériau de grille sur toute la surface et d'une structuration ultérieure, o) dépôt, à partir de la phase gazeuse, d'une couche d'oxyde de silicium étendue à toute la surface et agissant en tant qu'oxyde intercalaire (35),

p) fabrication simultanée des régions de source/drain (38) des transistors à canal n (B), de l'émetteur (37) et du contact de collecteur (38) de type n+ des transistors bipolaires (A) par implantation (39) d'ions réalisant un dopage de type n après masquage préalable (40) des régions (C) des transistors à canal p et des régions (A) des transistors bipolaires au moyen d'une laque photosensible à l'exception de la région d'émetteur (37) et de la région de collecteur de type n+ (38),

q) fabrication simultanée des régions de source/drain (41) des transistors à canal p (C) et du contact de base de type p+ (42) des transistors bipolaires (A) au moyen d'une implantation d'ions de bore (43) après masquage préalable (44) des régions (B) des transistors à canal n et des régions (A) des transistors bipolaires avec une laque photosensible, à l'exception de la région de base de type p+ (42),

r) élimination du masque (44) de laque photosensible, dégagement des régions des trous de contact, exécution de la métallisaton pour fabriquer les électrodes de raccordement et passivation.

2. Procédé suivant la revendication 1, caractérisé par le fait qu'on utilise un substrat en silicium (1) dopé du type p et possédant l'orientation (100) et une résistance électrique spécifique de 20 ohms·cm.

3. Procédé suivant la revendication 1, caractérisé par le fait qu'on utilise un substrat en silicium (1) dopé du type p et possédant l'orientation (100) et une résistance électrique spécifique égale à 0,02 ohm·cm, et que l'étape opératoire (a) est supprimée.

4. Procédé suivant les revendications 1 et 2, caractérisé par le fait que les étapes opératoires (a) et (b) sont supprimées.

5. Procédé suivant au moins l'une des revendications 1 à 4, caractérisé par le fait que l'implantation ionique (5) réalisée lors de l'étape opératoire a) est réalisée avec de l'antimoine avec une dose et une énergie égales respectivement à $3 \times 10^{15}$ cm$^{-2}$ et 80 keV.

6. Procédé suivant au moins l'une des revendications 1 à 5, caractérisé par le fait que la résistance électrique spécifique de la couche épitaxiale (7) dopée du type p, dépose lors de l'étape opératoire b), est réglée à 20 ohms·cm et que l'épaisseur de couche est réglée à environ 3 μm.

7. Procédé suivant au moins l'une des revendications 1 à 6, caractérisé par le fait que la couche double isolante (8, 9) intervenant lors de l'étape opératoire c) est formée par une couche thermique (8) de SiO$_2$ possédant une épaisseur de 50 nm et par une couche de nitrure de silicium possédant une épaisseur de 140 nm et déposée à partir de la phase gazeuse (CVD).

8. Procédé suivant au moins l'une des revendications 1 à 7, caractérisé par le fait que l'implantation profonde du collecteur réalisée lors de l'étape opératoire d) est réalisée avec des ions de phosphore avec une dose et une énergie égales respectivement à $3 \times 10^{15}$ cm$^{-2}$ et 80 keV.

9. Procédé suivant au moins l'une des revendications 1 à 8, caractérisé par le fait que l'implantation (12) des cuvettes réalisée conformément à l'étape opératoire e) est exécutée avec des ions de phosphore avec une dose et une énergie égales respectivement à $2 \times 10^{12}$ cm$^{-2}$ et 180 keV.

10. Procédé suivant au moins l'une des revendications 1 à 9, caractérisé par le fait que la pénétration des ions implantés et l'oxydation superficielle intervenant lors de l'étape opératoire f) sont exécutées de telle sorte que les régions (6, 14) dopées du type n pénètrent au moins sur une profondeur de 2,5 µm dans le substrat en silicium (1) dopé du type p.

11. Procédé suivant au moins l'une des revendications 1 à 10, caractérisé par le fait que la première implantation profonde de canal (16) intervenant lors de l'étape opératoire (g) est exécutée avec une dose et une énergie égales respectivement à $8 \times 10^{11}$ B$^+$ cm$^{-2}$ et 60 keV.

12. Procédé suivant au moins l'une des revendications 1 à 11, caractérisé par le fait que l'implantation (22) de champ à canal n intervenant lors de l'étape opératoire (i) est exécutée avec une dose et une énergie égales respectivement à $1,2 \times 10^{13}$ B$^+$ cm$^{-2}$ et 25 keV.

13. Procédé suivant au moins l'une des revendications 1 à 12, caractérisé par le fait que l'implantation d'ions de bore (25) pour la fabrication de la zone de base (27) conformément à l'étape opératoire (k) est exécutée avec une dose et une énergie égales respectivement à $9 \times 10^{13}$ B$^+$ cm$^{-2}$ et 80 keV.

14. Procédé suivant au moins l'une des revendications 1 à 13, caractérisé par le fait que l'oxydation de grille réalisée lors de l'étape opératoire l) est exécutée de telle sorte que l'épaisseur (28) de l'oxyde de grille se situe dans la gamme de 10 - 25 nm.

15. Procédé suivant au moins l'une des revendications 1 à 14, caractérisé par le fait que l'implantation d'ions de bore de canal (29), exécutée sur toute la surface lors de l'étape opératoire m), est exécutée avec une dose et une énergie égales respectivement à $2 \times 10^{11}$ B$^+$ cm$^{-2}$ et 25 keV.

16. Procédé suivant au moins l'une des revendinations 1 à 15, caractérisé par le fait qu'on utilise, comme matériaux de grille (33, 34) conformément à l'étape opératoire n), des métaux à pont de fusion élevé (refractory metals), des siliciures de métaux à point de fusion élevé, de préférence du siliciure de tantale, ou des couches doubles de polysilicium et de siliciures.

17. Procédé suivant au moins une des revendications 1 à 16, caractérisé par le fait que la couche d'oxyde de silicium (35), qui s'étend sur toute la surface et est mise en oeuvre lors de l'étape opératoire o) est réalisée sur une épaisseur de couche se situant dans la gamme de 50 - 200 nm par dissociation thermique de tétraétylorthosilicate.

18. Procédé suivant au moins l'une des revendications 1 à 17, caractérisé par le fait que les implantations de source/drain (39, 43) exécutées lors des étapes opératoires p) et q) sont exécutées pour une épaisseur de couche (35) de SiO$_2$ égale à 100 nm au moyen d'ions de phosphore et de bore, avec une dose et une énergie égales respectivement à $8 \times 10^{15}$ cm$^{-2}$ ou $4 \times 10^{15}$ cm$^{-2}$ et 80 ou 40 keV.

19. Procédé suivant au moins une des revendications 1 à 17, caractérisé par le fait que les implantations de source/drain (39/43) intervenant lors des étapes opératoires p) et q) sont exécutées pour une épaisseur de couche (35) de SiO$_2$ égale à 70 nm, à l'aide d'ions de phosphore ou de bore, avec une dose et une énergie égales respectivement à $4 \times 10^{15}$ cm$^{-2}$ et 80 ou 40 keV.

20. Dispositif à semiconducteurs contenant des transistors bipolaires intégrés et des transistors MOS complémentaires (CMOS) intégrés, et comportant des collecteurs (3, 6, 14) possédant des dopages différents et une borne de collecteur (6) auto-alignée, possédant une forme annulaire et s'étendant profondément, conformément au procédé suivant au moins l'une des revendications 1 à 19.

# FIG 1

# FIG 2

# FIG 3

1

## FIG 4

## FIG 5

## FIG 6

## FIG 7

## FIG 8

## FIG 9

## FIG 10

## FIG 11

## FIG 12

# FIG 13

# FIG 14